# EUROPEAN PATENT APPLICATION

(11) **EP 2 384 875 A1**
(43) Date of publication of application: **09.11.2011**
(21) Application number: 09839269.9
(22) Date of filing: 15.12.2009
(51) Int. Cl.: B29C 39/44, B29C 39/04, B29C 39/10, C03C 17/32, G02B 3/00, B29L 11/00

(54) **DEVICE OF PRODUCING WAFER LENS AND METHOD OF PRODUCING WAFER LENS**

(30) Priority: 30.01.2009 JP 2009020199
(71) Applicant: Konica Minolta Opto, Inc., Hachioji-shi Tokyo 192-8505 (JP)
(72) Inventor: FUJII Yuiti, Hachioji-shi Tokyo 192-8505 (JP); SARUYA Nobuhiro, Hachioji-shi Tokyo 192-8505 (JP); IMAI Toshiyuki, Hachioji-shi Tokyo 192-8505 (JP)
(74) Representative: Gille Hrabal Struck Neidlein Prop Roos
(86) International application number: PCT/JP2009/070888
(87) International publication number: WO 2010/087082

(57) **Abstract**

A device for producing a wafer lens, including: a stage which supports a glass substrate; an XY-axis moving mechanism which moves the stage on an XY-plane; an XY air slide guide mechanism which floats the stage relative to an XY guide by means of air, and guides the movement of the stage; a molding die to be filled with resin; a Z-axis moving mechanism which elevates or lowers the molding die; a Z air slide guide mechanism which floats the molding die relative to a Z guide by means of air, and guides the elevation and lowering of the molding die; and a control device which locks a moving position of the stage by controlling an activation and a deactivation of the XY air slide guide mechanism, and also locks a moving position of the molding die by controlling an activation or a deactivation of the Z air slide guide mechanism.

## Description

### TECHNICAL FIELD

The present invention relates to a device for producing a wafer lens, and a method for producing the wafer lens.

### BACKGROUND ART

In recent years, in the production field of optical lenses, technologies to obtain heat-resistant lens have been studied, wherein a lens portion formed of curable resin is provided on a glass substrate (see Patent Document 1). Using the above technology, as an example of the producing method of the optical lens, an offered technology is that a plurality of lens portions are molded with the curable resin on the glass substrate, which are so-called "wafer lenses", and after molding, each lens portion is individually cut off from the glass substrate.

As an example of the device of producing the wafer lens, a producing device is offered in which a molding die whose arranged position is stable, and a stage, being able to hold the glass substrate, against the molding die in the XY-plane, are used to form resin lenses on the glass substrate in plural times. In said producing device, the stage is shifted to a predetermined position, where the glass substrate faces the molding die. At said position, the molding die is pressed against the glass substrate to cure the resin, whereby a resin lens portion is formed on the glass plate. On said producing device, in order to shift the stage smoothly, studied was how to provide a well-known air slide guide mechanism.

### PRIOR ART DOCUMENT

### PATENT DOCUMENT

Patent Document 1: JP3926380

### SUMMARY OF THE INVENTION

### THE PROBLEM TO BE SOLVED BY THE INVENTION

However, in case of using the air slide guide mechanism for the stage, since the stage is held by means ofblowing air in a floating condition, when the molding die carrying the resin is pressed against the glass substrate, due to the compaction property of the air, the relative position between the glass substrate and the molding die changes within small variations, which makes it impossible to press the molding die against a predetermined position of the glass substrate. In this case, the pressing position of the molding die against the glass substrate shuts slightly, so that a positional shift of the lens portion on the glass substrate is adversely generated. In detail, if a positional shift is generated in a scanning direction on the XY-plane on the glass substrate, in case that the lens portions are formed on both surfaces of the glass substrate, an eccentric error of lens is adversely generated, and even in case that the lens portion is formed on a single surface, lens production yield is adversely lowered. Further, if a positional shift is generated in the vertical direction of the molding die, an error is generated on an axial thickness. Still further, in case that an alignment mark or an aperture diaphragm has been formed on the glass substrate, the positional shift against the lens is generated, which becomes a major problem.

Still further, the position of the stage in a traveling direction is held by the torque generated by a motor, because of no friction between a guide and a slide section. If a holding force due to torque generated by the motor is less than a load in the traveling direction, or if the rigidity of mechanical parts to be connected to the motor, or the slide section is less than the load in the traveling direction, a positional shift is adversely generated, which also results in errors.

Accordingly, the main objects of the present invention are to offer a device for producing a wafer lens, and a method for producing a wafer lens, in which a positional shift of a resin lens portion is effectively controlled against a glass substrate.

### MEANS TO SOLVE THE PROBLEM

According to an embodiment of the present invention, a device for producing a wafer lens is offered, wherein said device is characterized to include:
a stage which supports a glass substrate; an XY-axis moving mechanism which moves the stage on an XY-plane;
an XY air slide guide mechanism which floats the stage relative to an XY guide by means of air, and guides a movement of the stage caused by the XY-axis moving mechanism;
a molding die which is to be filled with resin;
a Z-axis moving mechanism which elevates or lowers the molding die;
a Z air slide guide mechanism which floats the molding die relative to a Z guide by means of air, and guides an elevation and lowering of the molding die caused by the Z-axis moving mechanism; and
a control device which conducts at least one of
   a locking operation of a moving position of the stage by controlling an activation and a deactivation of the XY air slide guide mechanism, and
   a locking operation of a moving position of the molding die by controlling an activation or a deactivation of the Z air slide guide mechanism.

According to another embodiment of the present invention, a method for producing a wafer lens is offered, wherein said method is characterized to include steps of
moving a glass substrate along an XY guide on an XY-plane to a position to face a molding die, while making the glass substrate to float by supply of first air,;
arranging the molding die at a predetermined height position by elevating or lowering the molding die along a Z guide to, while making a molding die to float by supply of second air; and elevating the molding die toward the glass substrate,
wherein in the step of elevating the molding die,
under a condition that the supply of the first air and the supply of the second air have been stopped,
the molding die is elevated toward the glass substrate.

### EFFECT OF THE INVENTION

According to the present invention, the positional shift of the resin lens portion is controlled against the glass substrate. That is, due to locking of the air slide section, positioning is conducted by the contact between solid objects. Concerning errors, the error due to gas compression is removed, and concerning the holding force, the frictional force functions as the holding force. Accordingly, the positional shift due to lack of a holding force does not tend to occur. The loads, which are against the motor and the connecting parts, are reduced, whereby deformation does not tend to occur, and errors reduce as a result. Further, the motor torque of the slide section and its connecting sections, and the rigidity of the circumferential parts can be reduced, so that the device can be downsized.

### BRIEF DESCRIPTIONS OF THE DRAWINGS

Fig. 1 is a plane view to show a general structure of a wafer lens.
Fig. 2 is a side view to show a general structure of a wafer lens.
Fig. 3 is a perspective view to show a general structure of a wafer lens producing device, relating to a preferable embodiment of the present invention.
Fig. 4 shows a plane view and side views of the wafer lens producing device, shown in Fig. 3.
Fig. 5 shows a general structure of an X-axis moving mechanism, to be used in a preferable embodiment of the present invention, which shows a cross-sectional view, cut along line A-A in Fig. 4.
Fig. 6 shows a general structure of a Y-axis moving mechanism, to be used in a preferable embodiment of the present invention, which shows a cross-sectional view, cut along line B-B in Fig. 4.
Fig. 7 is a cross-sectional view to show an XY-stage and a bed, to be used in a preferable embodiment of the present invention.
Fig. 8 is a cross-sectional view, cut along line C-C in Fig. 7.
Fig. 9 is a cross-sectional view to show a general structure of a molding die section, to be used in a preferable embodiment of the present invention.
Fig. 10 is a plane view to show the general structure shown in Fig. 9.
Fig. 11 is a cross-sectional view to show a general structure, in which a dispenser is arranged to face the molding die, in a preferable embodiment of the present invention.
Fig. 12 is a block diagram to show a general structure to be used in a preferable embodiment of the present invention.
Fig. 13 is a flow chart to detail a producing method of the wafer lens in accordance with time, relating to a preferable embodiment of the present invention.
Fig. 14 is a timing chart to generally show pressure conditions from a dispensing step to a separating step in Fig. 13.
Fig.15 generally shows a structure to adjust the parallelism between the glass substrate and the molding die, in the present embodiment.
Fig. 16 generally shows the coordinate transformation of the molding die on the two-dimensional surface, in the present embodiment.

### DETAILED DESCRIPTION OF THE PREFERRED EMBODIMENT

The preferable embodiment of the present invention will now be detailed, while referring to the drawings.

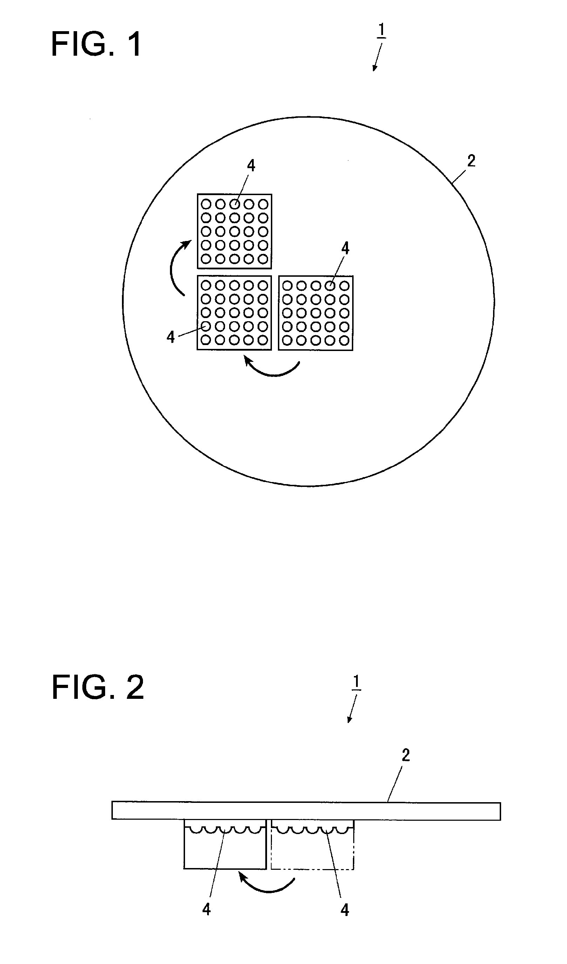

As shown in Fig. 1 and Fig. 2, molded wafer lens 1 includes circular glass substrate 2, and a plurality of convex lens sections 4. Glass substrate 2 shows an example of the substrates.

The plurality of convex lens sections 4 are arranged in an arrayed arrangement on the surface of glass substrate 2. Fine structures, such as diffraction grooves or steps, can be formed on an optical surface of convex lens section 4. Further, a concave lens can also be used.

Since Fig. 1 and Fig. 2 show middle stages of the production process, convex lens sections 4 are formed only on a part of the surface of glass substrate 2. In the present embodiment, convex lens section 4 is sequentially formed on a single glass substrate 2 by the molding die (see arrows to show the production process in Fig. 1 and Fig. 2), and finally, glass substrate 2 is individually divided to include a single convex lens section 4.

Further, the sequential production process to form convex lens sections 4 on glass substrate is not limited to a specific production process. Random production process can be applied, or a process opposite to the arrowed production process shown in Fig. 1 can also be applied to the present embodiment

Convex lens section 4 is formed of a light curable resin. As the light curable resins, acrylic resin, allyl ester resin, PDMS, and epoxy resin can be used. These resins can be reacted to be cured by radical polymerization or cationic polymerization.

Next, wafer lens producing device 10, which is used when wafer lens 1 is produced, will now be detailed.

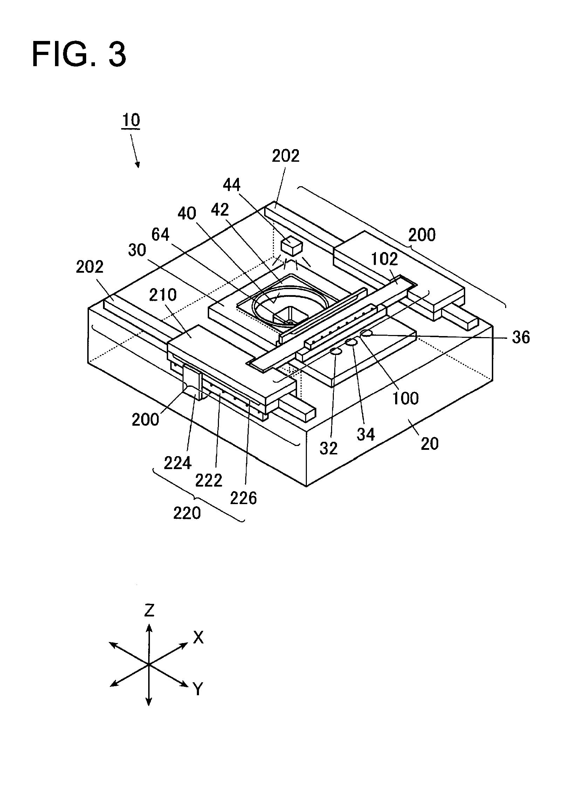

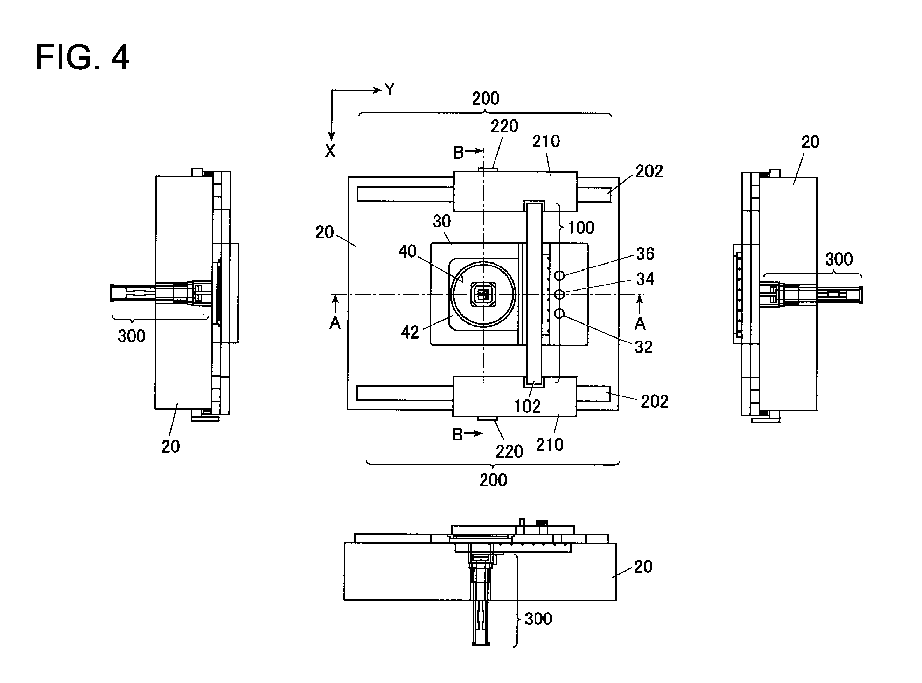

As shown in Fig. 3 and Fig. 4, wafer lens producing device 10 is structured of bed 20, which is a rectangular solid, XY-stage 30, which is mounted on bed 20, X-axis moving mechanism 100, which moves XY-stage 30 in an X-axis direction, and paired Y-axis moving mechanisms 200, which move XY-stage 30 in the Y-direction.

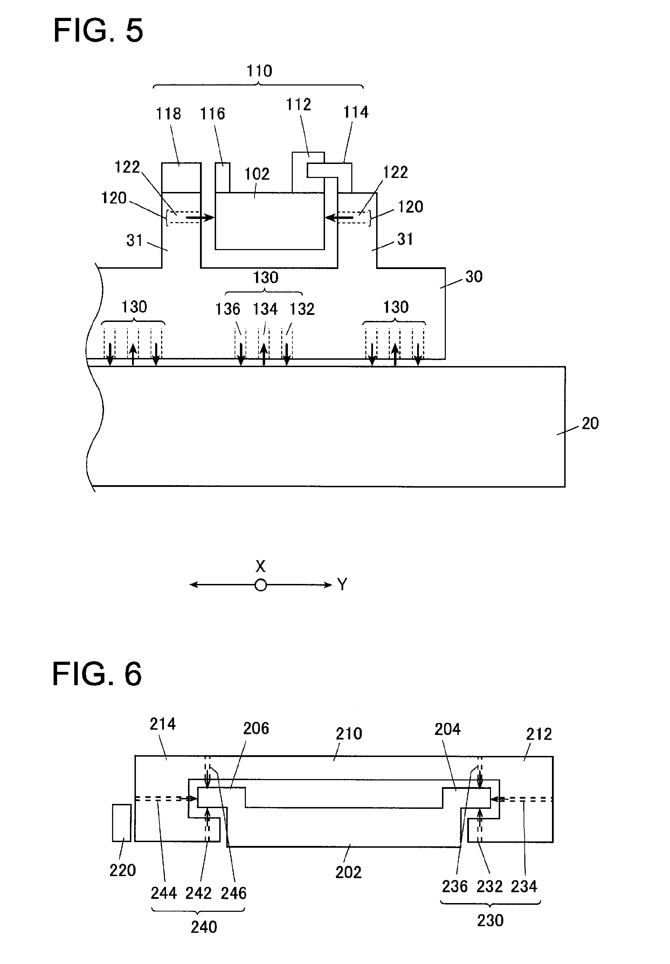

As shown in Fig. 4 and Fig. 5, X-axis moving mechanism includes X-axis guide 102, which is arranged in the X-axis direction. As shown in Fig. 5, XY-stage 30 is mounted below X-axis guide 102. Paired projected sections 31, which are arranged in the X-axis direction, are formed on XY-stage 30. Between projected sections 31, X-axis guide 102 is arranged.

As shown in Fig. 5, X-axis moving mechanism 100 includes linear motor 110 which actually moves XY-stage 30 in the X-direction. Linear motor 110 includes a well-known mechanism which is structured of stator 112, rotor 114, scale 116, and sensor 118.

Stator 112 is mounted on X-axis guide 102. Rotor 114, mounted on one of projected sections 31 on XY-stage 30, is movable along X-axis guide 102. Scale 116 is mounted on X-axis guide 102. Sensor 118 is mounted on another projected section 31 on XY-stage 30.

X-axis moving mechanism is configured to work in such a way that while sensor 118 detects scale 116, rotor 114 moves along stator 112, so that XY-stage 30 can move a predetermined distance in the X-axis direction along X-axis guide 102.

Air slide guide mechanism 120 is arranged on each projected section 31 of XY-stage 30. Air slide guide mechanism 120 has ejection hole 122 to jet air. Air slide guide mechanism 120, after being activated, jets air from each ejection hole 122 to X-axis guide 102, so that XY-stage 30 levitates above X-axis guide 102.

A plurality of air slide guide mechanisms 130 are mounted at a lower portion of XY-stage 30. Each air slide guide mechanism 130 has two ejection holes 132 and 136 to jet air, and one suction hole 134 to vacuum air. Air slide guide mechanism 130, after being activated, jets air from ejection holes 132 and 136 onto bed 20, while vacuums air from suction hole 134, so that XY-stage levitates at a predetermined height above bed 20.

Since XY-stage 30 levitates above X-axis guide 102 and bed 30 by air slide guide mechanisms 120 and 130, X-axis moving mechanism 100 can smoothly move XY-stage 30.

As shown in Fig. 3 and Fig. 4, Y-axis moving mechanisms 200 has paired Y-axis guides 202, mounted in the Y-axis direction. Paired Y-axis moving bodies 210 are provided on Y-axis guide 202.

Both ends of X-axis guide 102 are fixed on each Y-axis moving body 210. Y-axis moving body 210 is configured to move along Y-axis guide 202 in the Y-axis direction, under a condition that Y-axis moving body 210 supports X-axis guide 102, and XY-stage 30 which is supported by X-axis guide 102.

In more detail, Y-axis moving mechanism 200 includes linear motor 220. In the same way as linear motor 110 of X-axis moving mechanism 100, linear motor 220 is structured of stator 222, rotor 224, scale 226, and a sensor (the sensor is not shown in a figure). While the sensor detects scale 226, rotor 224 moves along stator 222, so that Y-axis moving body 210 can move a predetermined distance in the Y-axis direction, along Y-axis guide 202 .

As shown in Fig. 6, hooking sections 212 and 214, which are formed to be hooks, are formed on both ends of Y-axis-moving body 210. End portions 204 and 206 of Y-axis guide 202 are arranged with a clearance, to engage inner portions of hook sections 212 and 214, respectively.

Air slide guide mechanism 230 is arranged in hooking section 212, while air slide guide mechanism 240 is arranged within hooking section 214. Air slide guide 230 has ejection holes 232, 234, and 236, to jet air in three directions (in the upward, sideward, and downward directions). Air slide guide 240 also has ejection holes 242, 244, and 246, to jet air in three directions (in the upward, sideward, and downward directions).

Air slide guide 230 is activated to jet air from ejection holes 232, 234, and 236 to end portion 204 of Y-axis guide 202, while air slide guide 240 is activated to jet air from ejection holes 242, 244, and 246 to end portion 206 of Y-axis guide 202, whereby Y-axis moving body 210 can float above Y-axis guide 202. Further, if some or all of the ejection holes of air slide guide mechanisms 230 and 240 are deactivated, Y-axis guide 202 can be placed on and suctioned to an inner surface of Y-axis moving body 210.

As shown in Fig. 3 and Fig. 4, on XY-stage 30, installed are dispenser 32 to drip resin onto glass substrate 2, laser length measuring machine 34 to measure the flatness (inclination), the height, and the position ofmolding die 64, and a microscope 36 to be used for an alignment operation of glass substrate 2 against molding die 64.

As shown in Fig. 3, through-hole 40, whose shape is circular as the top view, is formed from the front surface through the rear surface, wherein glass substrate 2 is supported over through-hole 40.

In detail, since a step is formed on through-hole 40, glass substrate 2 is fixed on the step, by a spring which is not illustrated. In order to cover through-hole 40, cover section 42, whose shape is quadrilateral as the top view, is mounted on XY-stage 30. Cover section 42 is structured of an optical transparent member, such as a quartz plate, while light source 44 is mounted above cover section 42.

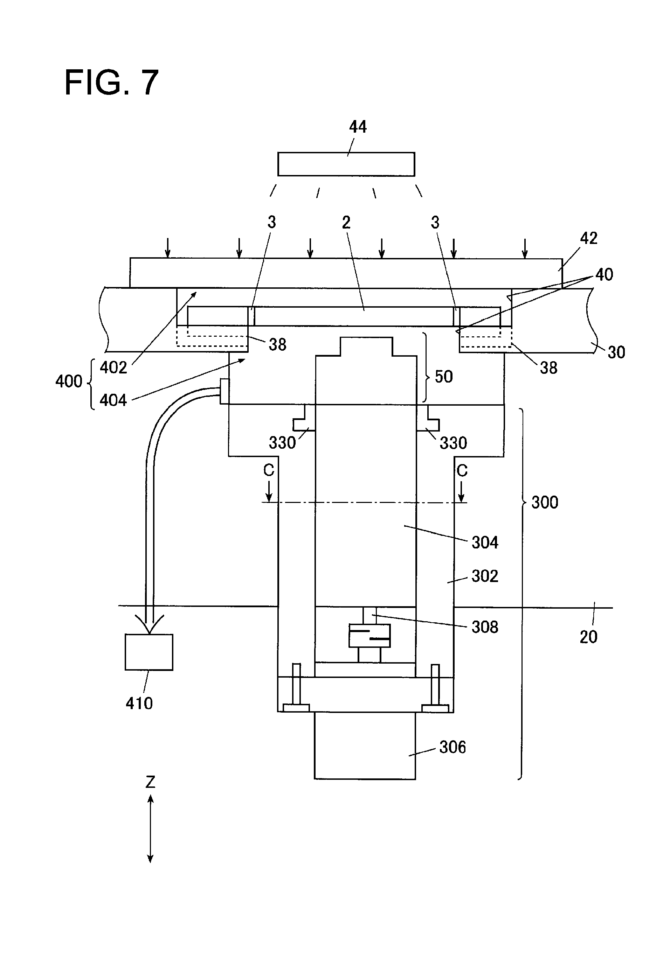

As shown in Fig. 7, molding die section 50 to form convex lens section 4 of wafer lens 1, and Z-axis moving mechanism 300 to vertically move molding die section 50 in a Z-axis direction, are installed within bed 20. Molding die section 50 is installed on the top portion of Z-axis moving mechanism 300 (Z-stage 304).

Z-axis moving mechanism 300 includes:
Z-axis guide 302, which is a square tube having a flange on a top portion,
Z-stage 304 to move in the Z-axis direction within Z-axis guide 302, and
motor 306 to move Z-stage 304 in the Z-axis direction (vertical direction).

Motor 306 carries a potentiometer, and shaft 308 is connected to motor 306. Concerning Z-axis moving mechanism 300, shaft 308 is configured to vertically elongate and contract by motor 306, and due to this motion, Z-stage 304 and molding die section 50 are moved vertically.

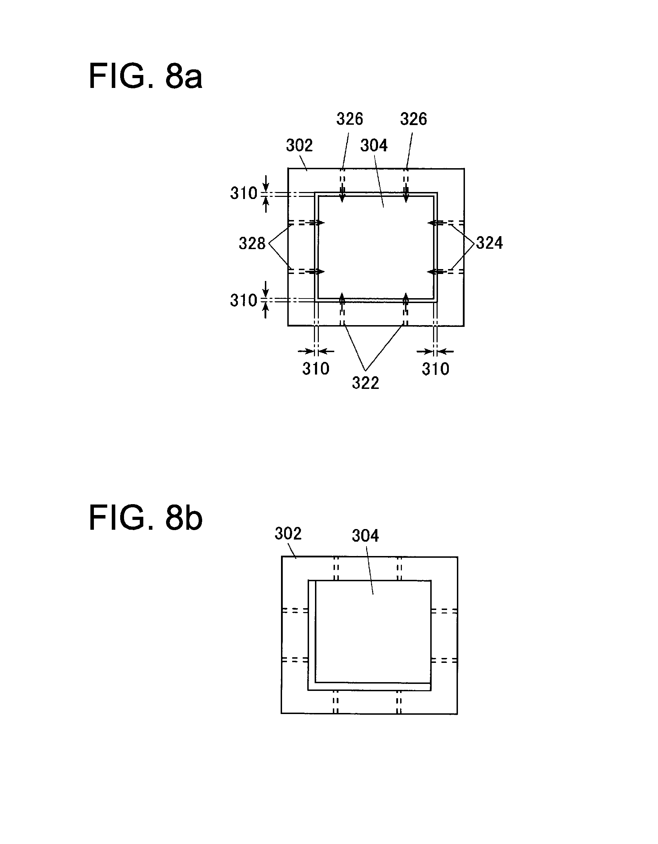

As shown in Fig. 8(a), clearance 310 is provided between an inner peripheral surface of Z-axis guide 302 and a side surface of Z-stage 304.

Air slide guide mechanism 320 is mounted on Z-axis guide 302. Air slide guide mechanism 320 has ejection holes 322, 324, 326 and 328 to jet air. Air slide guide mechanism 320, being activated, jets air from ejection holes 322, 324, 326 and 328 onto Z-stage 304, to levitate Z-stage 304.

In addition, as shown in Fig. 7, the inner peripheral surface, to form a flange of Z-axis guide 302, is sealed with sealing member 330, such as silicon grease, an oil seal, and an O-ring, whereby the clearance between Z-axis guide 302 and Z-stage 304 becomes air-tight, so that air within clearance 310 cannot leak outward.

Further, in order to obtain the above effect, more preferable is to prepare a flange section around Z-stage 304, while metal bellows are used to cover between Z-axis guide 302, which is arranged to be fixed, and the flange section of Z-axis guide 302, all of which are not illustrated.

As shown in Fig. 7, empty space section 400 is formed on an area surrounded by cover section 42, XY-stage 30, bed 20, and Z-axis guide 302. Empty space section 400 is compartmented by glass substrate 2, installed on XY-stage 30, into: upper empty space section 402, formed between glass substrate 2 and cover section 42, and lower empty space section 404, formed between glass substrate 2 and Z-axis moving mechanism 300.

Continuous hole 3, which communicate upper empty space section 402 with lower empty space section 404, is formed on a peripheral border of glass substrate 2, so that no pressure difference can form between upper empty space section 402 and lower empty space section 404. Since lower empty space section 404 is connected to decompression mechanism 410, such as a vacuum pump, empty space section 400 becomes a reduced-pressure condition, due to the operation of decompression mechanism 410.

In addition, instead of continuous hole 3, formed on glass substrate 2, continuous hole 38 can be formed in XY-stage 30, which is shown by the dotted lines in Fig. 7.

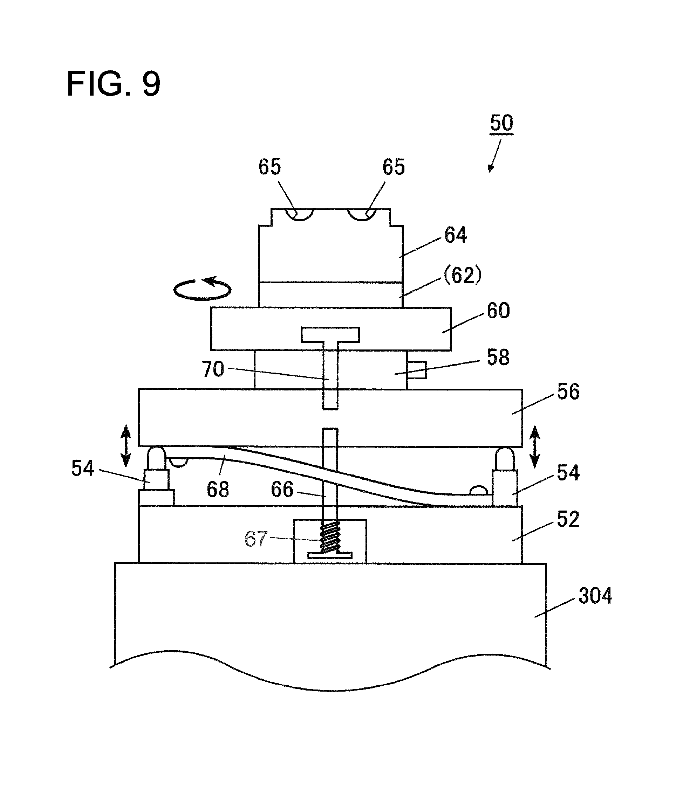

As shown in Fig. 9, molding die section 50 includes first supporting plate 52, piezo actuator 54, second supporting plate 56, pressure sensor 58, third supporting plate 60, and molding die 64, which are provided on Z-stage 304 in the above order.

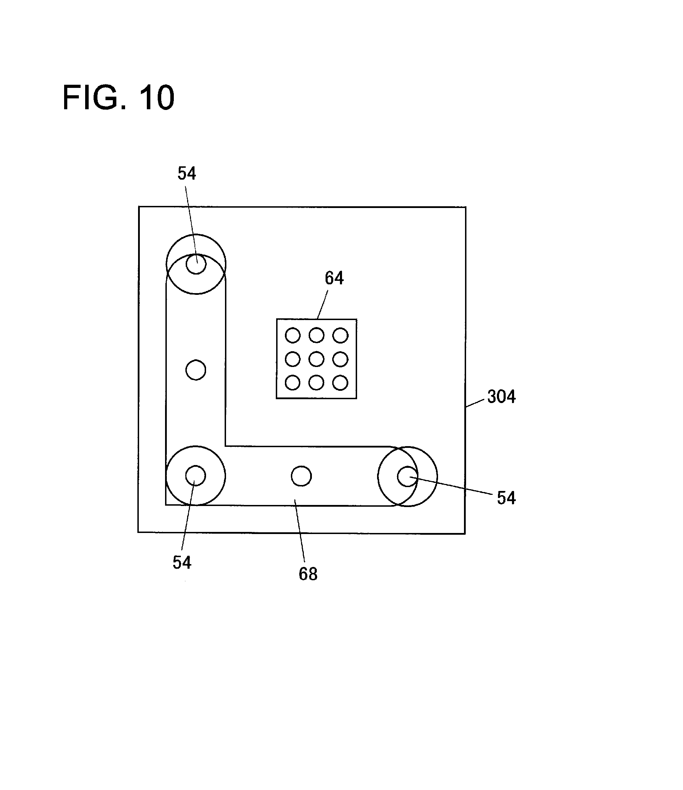

First supporting plate 52 and second supporting plate 56 are connected to each other by precompressing screw 66, and both plates are urged to be nearer to each other by spring 67. Three piezo actuators 54 and L-shaped plate spring 68 are installed between first supporting plate 52 and second supporting plate 56 (see Fig.10). Second supporting plate 56 and third supporting plate 60 are connected to each other by screw 70, and pressure sensor 58 is installed between second supporting plate 56 and third supporting plate 60. Further, as to be detailed later, θ-stage 62 can be installed between third supporting plate 60 and molding die 64, to rotate molding die 64.

As shown in Fig. 10, piezo actuators 54 are mounted on three portions of first supporting plate 52, to support second supporting plate 56 at three points. On molding die section 50, operation of each piezo actuator 54 is controlled based on output values of pressure sensor 58, whereby inclinations are adjusted for second supporting plate 56, third supporting plate 60 and molding die 64. As a result, molding die 64 and glass substrate 2 are held parallel to each other, and after resin has been applied into molding die 64, pressure against the resin is controlled to be a desired value, whereby mold clamping and transcription forming are preferably conducted.

The present embodiment is structured of three piezo actuators 54. However, if the above-described paralleling movement can be conducted desirably, and if positions of the piezo actuators are desirable for weight control, the number is not limited to three.

A plurality of cavities 65 (being concave sections) are formed in the shape of array in molding die 64. The surface (being a molding surface) of cavity 65 is a negative shape to correspond to convex lens section 4 of wafer lens 1.

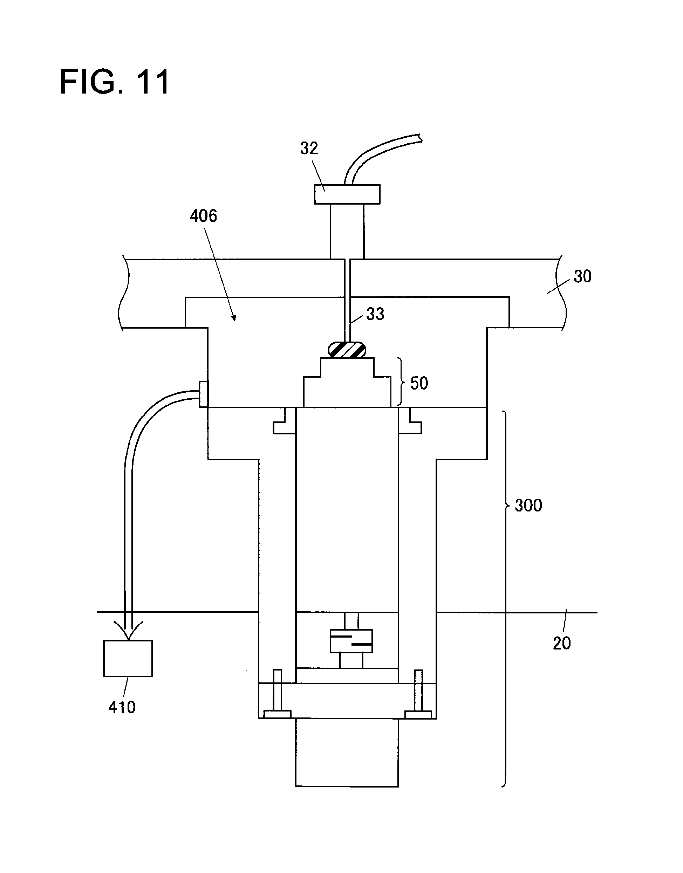

As shown in Fig. 11, dispenser 32 has a needle section through which the resin drips, and said needle section 33 passes through XY-stage 30. In a condition that dispenser 32 and molding die section 50 are placed to face each other, empty space section 406 is formed in an area which is surrounded by XY-stage 30, bed 20, and Z-axis moving mechanism 300. In addition, the top of needle section 33 of dispenser 32 is arranged in empty space section 406. In this condition, due to the operation of decompression mechanism 410, empty space section 406 is in a reduced-pressure condition.

Various sections shown in Fig.11 are the same as those shown in Fig. 7, so that the same reference numerals are given to the same sections, and their explanations are abbreviated.

Wafer lens producing device 10, having the above structures, includes control device 500. Connected to control device 500, are dispenser 32, laser length measuring machine 34, microscope 36, light source 44, molding die section 50 (such as piezo actuator 54, pressure sensor 58, and θ-stage 62), X-axis moving mechanism 100, Y-axis moving mechanism 200, Z-axis moving mechanism 300, air slide guide mechanisms 120, 130, 230, 240, and 320, and decompression mechanism 410. Control device 500 is configured to receive detected results from these members, and to control their operations (starting, stopping, or the like).

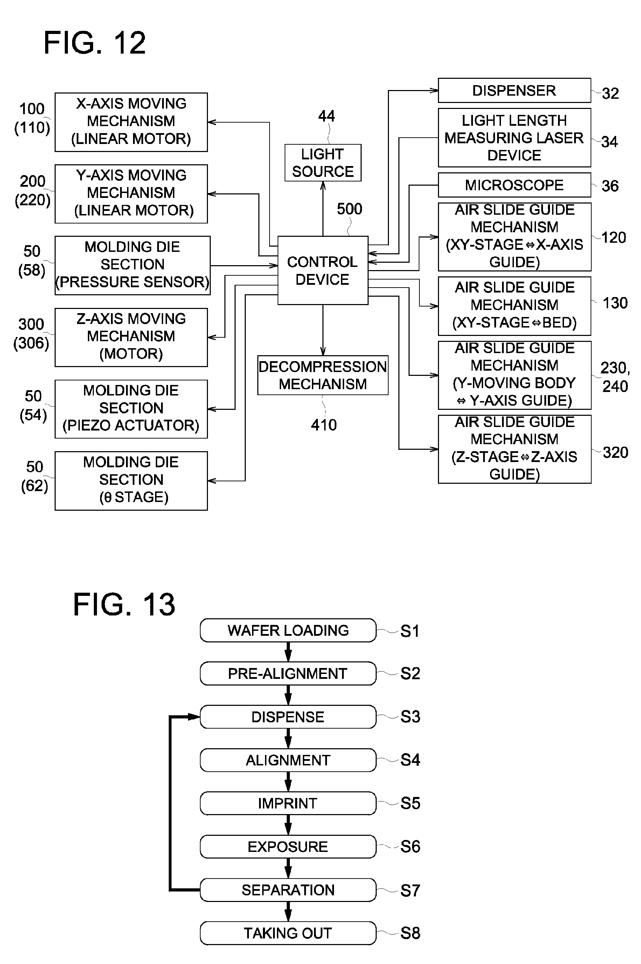

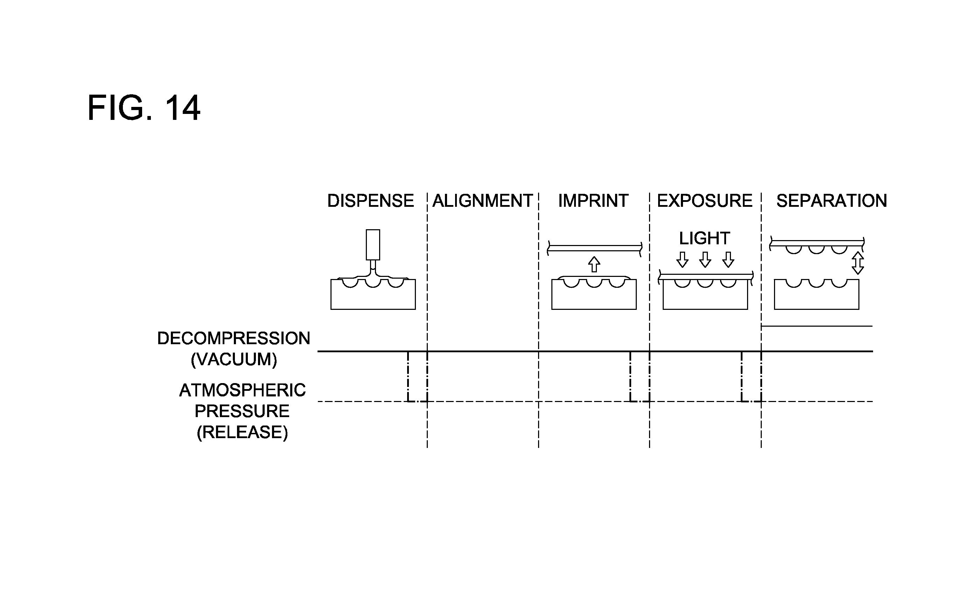

Next, a producing method of wafer lens 1, using above-detailed wafer lens producing device 10, will be explained, while referring to Fig. 13 and Fig. 14.

Firstly, glass substrate 2 is installed on XY-stage 30 (which is wafer loading step S1), and through-hole 40 of XY-stage 30 is covered with cover section 42 (see Fig. 7).

After that, X-axis moving mechanism 100 (being inear motor 110), Y-axis moving mechanism 200 (being linear motor 220), air slide guide mechanisms 120,130,230, and 240 are activated so that XY-stage 30 is floated by air and moved in the X-axis direction and Y-axis direction, whereby dispenser 32 is positioned to be aligned just above molding die 64 (which is pre-alignment step S2).

In this case, an alignment mark is preliminarily applied on a predetermined position on bed 20. In the pre-alignment step, said alignment mark is observed through microscope 36, so that the position of dispenser 32 is aligned.

After the position of dispenser 32 has been aligned, air slide guide mechanisms 120,130, 230 and 240 are deactivated, so that XY-stage 30 and bed 20 come into close contact with each other, and are locked with each other. Due to this, XY-stage 30 is fixed at its position. Under this condition, predetermined amounts of resin are dripped onto molding die 64 of molding die section 50, from needle section 33 of dispenser 32 (which is dispensing step S3, see Fig. 11).

At this time, as shown in solid lined portions in Fig. 14, decompression mechanism 410 is controlled so that empty space section 406 is depressurized. Depressurization means that empty space section 406 is depressurized to a vacuum state, that is, empty space section 406 is vacuumed to be equal to or less than 10⁻² Mpa.

Since dispensing step S3 is processed under the depressurized condition, air bubbles are prevented from entering the resin.

In addition, in the present embodiment, the operations are conducted in the vacuumed condition, from dispensing step S3 to separating step S7, and the definition of the vacuumed condition is based on the above description.

After that, air slide guide mechanisms 120,130,230, and 240 are activated so that XY-stage 30 is floated by air, and moved in the X-axis direction and Y-axis direction, whereby previously installed glass substrate 2 is aligned just above molding die 64 of molding die section 50 (which is alignment step S4, see Fig. 7).

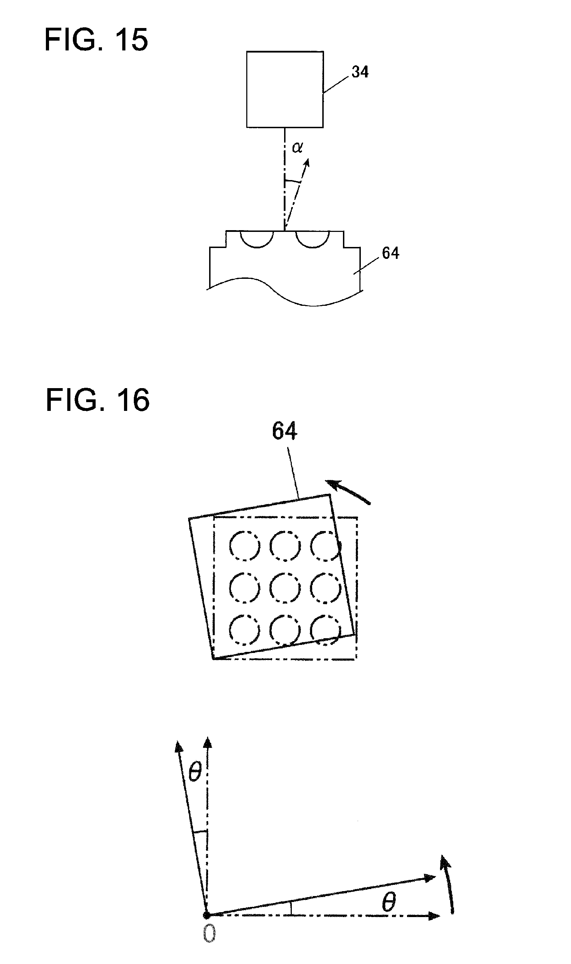

After that:
(1) As shown in Fig.15, well-known laser length measuring machine 34 is positioned just above molding die 64. Subsequently, air slide guide mechanisms 120,130,230 and 240 are deactivated, so that XY-stage 30 and bed 20 come into close contact with each other, to be in a locked condition with each other. Due to this, glass substrate 2 is fixed at its position.
   At the same time, motor 306, and air slide guide mechanism 320 are controlled to jet air from ejection holes 322, 324, 326 and 328, so that Z-stage 304 is positioned at a predetermined height. Subsequently, as shown in Fig. 8(b), for example, ejection holes 322 and 328 are controlled to jet air so that a portion of Z-stage 304 comes into contact with the inner surface of Z-axis guide 302. Due to this action, the position of molding die section 50 is supported constantly in a locked condition, by the frictional force between Z-stage 304 and Z-axis guide 302.
(2) Subsequently, by laser length measuring machine 34, the height of more than three points is measured. From the measured results, based on the inclination of the top surface of molding die 64, and the outputted value of the measured heights of molding die 64 (which is variance value of angle α, see Fig.15), piezo actuator 54 is controlled, so that the lower surface of glass substrate 2 and the upper surface of molding die 64 are positioned to be parallel with each other.
   Subsequently, the locked condition is released, and microscope 36 is arranged just above molding die 64. Air slide guide mechanisms 120,130,230 and 240 are deactivated, so that XY-stage 30 and bed 20 come into close contact with each other, and are locked to each other. Due to this, glass substrate 2 is fixed at its position.
   At the same time, air slide guide mechanism 320 is controlled to jet air from ejection holes 322 and 328, as shown in Fig. 8(b), so that a portion of Z-stage 304 comes into contact with the inner surface of Z-axis guide 302. Due to this, the position of molding die section 50 is supported constantly, by the frictional force between Z-stage 304 and Z-axis guide 302.
   Accordingly, due to the contact of Z axis guide 302 with Z-stage 304, since molding die 64 is mounted on Z-stage 304, molding die 64 can always be supported at a constant position and at a constant angle, against Z-axis guide 302. At a result, under a condition that locking between them is released, Z-stage 304 and molding die 64 can be moved smoothly, while under the locked condition, the forming operation can be conducted at the same attitude as that of the adjustment operation, which is a merit.
(3) Subsequently, molding die 64 is detected by microscope 36, whereby a real arranged position of molding die 64 is obtained, based on the detected results. The axial coordinates of an initial position of molding die 64, which have been previously set in control device 500, are transferred to agree with the real arranged position.

In more detail, from the top of molding die 64, at least two points on molding die 64 are viewed and recognized by microscope 36, whereby one point is determined to be an origin, while the other point is determined to be a correcting point. For example, alignment marks are preliminarily plotted at the diagonal positions on molding die 64. One alignment mark is determined to be origin O, while the other alignment mark is determined to be a correcting point. In the present embodiment, microscope 36 is used as an example of the position detecting devices, to detect the arranged position of molding die 64.

Subsequently, a straight line, to be used for the coordinate transformation, is calculated, wherein said straight line joins origin O and the correcting point. Subsequently, a variance is calculated, which is between said calculated straight line and a previously determined axis coordinate, so that the axis coordinate is transferred, based on said variance (which is variance of angle θ, see Fig. 16). That is, on control device 500, the arrangement position af molding die 64 on the plane surface is previously determined as the axis coordinate. Then, the variance is obtained, which is between said previously determined axis coordinate and the straight line to be used for the coordinate transformation, viewed by microscope 36 and calculated. Then, as shown in Fig. 16, the previously determined axis coordinate (see two-dashed lines) is transferred to the axis coordinate (see real lines), calculated by said variance. Due to this transformation, the two dimensional relative positional relationship can be fixed which is between molding die 64 and glass substrate 2, whereby the movement of glass substrate 2 against molding die 64 can be precisely conducted.

In addition, it is also possible to conduct the rotating movement of molding die 64 in such a way that instead of the transformation of the above axis coordinate, to be conducted by control device 500, θ-stage 62 is set up to rotate molding die 64 on molding die section 50 (see Fig. 9), whereby θ-stage 62 is controlled to correspond molding die 64 to the coordinate axes, on which molding die 64 is previously determined (that is, the varied axis coordinate is turned back to the original condition).

In this condition, the position of molding die section 50 is controlled, so that molding die 64 is elevated to a predetermined position against glass substrate 2, whereby molding die 64 is supported at said predetermined position. (which is imprinting step S5).

In more detail, Z-axis moving mechanism (being motor 306) is activated to elongate shaft 308 upward, so that Z-stage 304 is moved upward.

In this case, based on an output value from a potentiometer, which is built in motor 306, the operation of motor 306 is controlled, so that Z-stage 304 is moved to a predetermined height. As a result, the resin is pressed by glass substrate 2, and is gradually spread out, so that the resin fills cavity 65 of molding die 64.

Also in the imprinting step S5, decompression mechanism 410 is controlled to reduce the pressure in empty space section 400.

Under a reduced pressure condition, the resin is pressed against glass substrate 2, whereby air bubbles can be prevented from entering the resin. Further, since empty space section 400 is controlled to be in the reduced pressure condition, no pressure difference is generated between upper empty space section 402 and lower empty space section 404, whereby glass substrate 2 can be prevented from being curled or deformed.

After that, while Z-stage 304 is supported at the set position, light source 44 is controlled to radiate light to cure the resin (which is light exposing step S6).

In this condition, since decompression mechanism 410 is controlled to reduce the pressure in empty space section 400, oxygen inhibition against the resin is prevented, so that the resin can be certainly cured. A similar effect can also be obtained by substituting a gas other than oxygen.

However, when the resin is going to be cured (when the resin is being cured, or after the resin has been cured), in case that Z-stage 304 is still supported at the predetermined height, even though the resin is cured and constricted, glass substrate 2 cannot follow the constriction of the resin, whereby the distortion is generated within the resin, or the transcription of the surface shape of cavity 65 may be insufficiently conducted onto the resin.

To overcome these situations, light source 44 is activated for a predetermined time interval, and after a certain amount of light has been radiated onto the resin, molding die section 50 is controlled to keep the pressing force of molding die 64 against glass substrate 2 at a predetermined pressure. In more detail, based on the outputted value of pressure sensor 58, piezo actuator 54 is activated to move molding die 64 upward. In order to prevent an adverse positional shift, molding die 64 is moved upward, under a condition that XY air slide guide mechanisms 120,130,230 and 240 are deactivated, and a condition that only ejection holes 322, 324 of Z air slide guide mechanism 320 are deactivated, to make Z-stage 304 to be in contact with Z-axis guide 302.

After that, light source 44 is deactivated, so that the light radiation onto the resin is stopped. After the stop of light radiation, motor 306 is activated to shrink shaft 308 downward, whereby Z-stage 304 is moved downward. Due to these operations, the cured resin and glass substrate 2 are separated from molding die 64 (which is separating step S7).

At the above step, since decompression mechanism 410 is controlled to decrease the pressure in empty space section 400, atmospheric pressure is not applied, whereby the separation can be effectively conducted. Consequently, as shown in Fig. 1 and Fig. 2, plural convex lens sections 4, corresponding to cavity 65 of single molding die 64, can be formed on glass substrate 2.

After that, dispensing step S3, imprinting step S5, light exposing step S6, and separating step S7 are repeated for the predetermined times, to subsequently form additional plural convex lens sections 4 on glass substrate 2 (see Fig. 1 and Fig. 2), whereby wafer lens 1 is produced.

After the predetermined number of convex lens sections 4 has been formed on glass substrate 2, moving mechanisms 100,200, and 300, and air slide guide mechanisms 120,130, 230, 240, and 320 are activated, whereby, XY-stage 30, and Z-stage 304 are moved to the predetermined positions, and cover 42 is removed from XY-stage 30, so that glass substrate 2 is taken out (which is ejecting step S8).

In addition, in the present embodiment, convex lens sections 4 are subsequently formed on glass substrate 2, by a unit of the molding die, which is a "step and repeat method". However, a molding die, exhibiting a large diameter, corresponding to the size (being the area) of glass substrate 2, can be used instead of molding die 64. Then, a desired number of convex lens sections 4 can be formed as the mass treatment, which is a "package method".

Further, in the present embodiment, from dispensing step S3 to separating step S7, adjacent areas of glass substrate 2 are controlled to be in a reduced pressure condition. In both the "step and repeat method", and the "package method", it is also possible to control them by such a structure in which, wafer lens producing device 10 (in which control device 500 is not included) is totally installed within a closed system, such as a chamber, whereby wafer lens producing device 10, including the adjacent area of glass substrate 2, is totally controlled under the reduced pressure condition.

Still further, in the present embodiment, it has been explained that the activation and the deactivation of XY-air slide mechanism, and the activation and the deactivation of Z-air slide guide mechanism are conducted together. However, it is also possible to control that at least one of them is controlled.

According to the above described embodiment, the steps from alignment step S4 to separating step S7 are conducted, under the condition that air slide guide mechanisms 120, 130, 230, 240, and 320 have been deactivated by control device 500 (in which, air slide guide mechanism 320 has been partially deactivated), so that the relative position between glass substrate 2 and molding die 64 does not tend to change, whereby positional disagreement of convex lens section 4 against glass substrate 2 can be effectively controlled.

In addition, the present invention is not limited to the above described embodiment These detailed structures and operations of the present embodiment can be appropriately changed within the scope of this invention as long as it does not deviate from the scope and content of the present invention.

For example, in the above embodiment, the pressure within empty space section 400 is reduced in the steps from imprinting step S5 to exposing step S6. However, it is also possible to make a structure in which, the pressure within only lower empty space section 404 is decreased, while continuous hole 3, formed in glass substrate 2, is not used.

In this case, as shown by the dashed lines in Fig. 14, at least one step among dispensing step S3, imprinting step S5, and light exposing step S6, lower empty space section 404 should be released to the atmospheric pressure.

In case that the resin is filled under a reduced pressure condition in dispensing step S3, air bubbles can be effectively prevented from entering the resin, however, the air bubbles tend to be adversely generated by the surface tension of the resin. To overcome this situation, after the reduced pressure condition is made, if the resin is opened to atmospheric pressure, the generation of the air bubbles can be effectively prevented, whereby the resin fills every portion of cavity 65.

In case that both of upper empty space section 402 and lower empty space section 404 are under a reduced pressure condition, no pressure difference exists between upper empty space section 402 and lower empty space section 404, whereby air bubbles are prevented from entering the resin. For example, if upper empty space section 402 is controlled to be under atmospheric pressure, while lower empty space section 404 is controlled to be under a reduced pressure condition, glass substrate 2 is curled or deformed by the pressure difference. Accordingly, in case that lower empty space section 404 is changed from a reduced pressure condition to atmospheric condition, glass substrate 2 can be kept as a flat surface, so that the imprint operation can be conducted on the flat surface.

In case that the resin is exposed under a reduced pressure condition in light exposing step S6, oxygen inhibition against the resin is prevented, so that the resin can be assuredly cured, and the resin is then released to atmospheric condition, the transcription is more effectively improved. The releases to atmospheric pressure during these steps are shown by the chain lines in Fig.14.

Further, the above embodiment shows that convex lens section 4 is formed of resin by molding die 64. The above embodiment is applicable to a case in which a resin sub-master is formed by molding die 64 serving as a master, or to a case in which molding die 64 is used as an intermediate molding die.

### EXPLANATION OF THE NUMERIC SYMBOLS

- 1: wafer lens
- 2: glass substrate
- 3: continuous hole
- 4: convex lens section
- 10: device for producing wafer lens
- 20: bed
- 30: XY-stage
- 31: projected section
- 32: dispenser
- 33: needle section
- 34: laser length measuring machine
- 36: microscope
- 38: continuous hole
- 40: through-hole
- 42: cover section
- 44: light source
- 50: molding die section
- 52: first supporting plate
- 54: piezo actuator
- 56: second supporting plate
- 58: pressure sensor
- 60: third supporting plate
- 62: θ-stage
- 64: molding die
- 65: cavity
- 66: screw
- 68: plate spring
- 70: screw
- 100: X-axis moving mechanism
- 102: X-axis guide
- 110: linear motor
- 112: stator
- 114: rotor
- 116: scale
- 118: sensor
- 120: air slide guide mechanism
- 122: ejection hole
- 130: air slide guide mechanism
- 132, 136: ejection hole
- 134: suction hole
- 200: Y-axis moving mechanism
- 202: Y-axis guide
- 204, 206: end portion
- 210: Y-axis moving body
- 212, 214: hooking section
- 220: linear motor
- 222: stator
- 224: rotor
- 226: scale
- 230: air slide guide mechanism
- 232, 234, 236: ejection hole
- 240: air slide guide mechanism
- 242, 244, 246: ejection hole
- 300: Z-axis moving mechanism
- 302: Z-axis guide
- 304: Z-stage
- 306: motor
- 308: shaft
- 310: clearance
- 320: air slide guide mechanism
- 322, 324, 326, 328: ejection hole
- 330: sealing member
- 400: empty space section
- 402: upper empty space section
- 404: lower empty space section
- 406: empty space section
- 410: decompression mechanism
- 500: control device

## Claims

1. A device for producing a wafer lens, **characterized in that**:
a stage which supports a glass substrate;
an XY-axis moving mechanism which moves the stage on an XY plane;
an XY air slide guide mechanism which floats the stage relative to an XY guide by means of air, and guides a movement of the stage caused by the XY-axis moving mechanism;
a molding die to be filled with resin;
a Z-axis moving mechanism which elevates or lowers the molding die;
a Z air slide guide mechanism which floats the molding die relative to a Z guide by means of air, and guides an elevation and lowering of the molding die caused by the Z-axis moving mechanism; and
a control device which conducts at least one of
a locking operation of a moving position of the stage by controlling an activation and a deactivation of the XY air slide guide mechanism, and
a locking operation of a moving position of the molding die by controlling an activation or a deactivation of the Z air slide guide mechanism.

2. The device for producing the wafer lens, described in Claim 1, **characterized in that**
the control device conducts both of
the locking operation of the moving position of the stage, being positioned by the activation or the deactivation of the XY air slide guide mechanism, and
the locking operation of the moving position of the molding die, being positioned by the activation or
the deactivation of the Z air slide guide mechanism.

3. The device for producing the wafer lens, described in Claim 2, **characterized in that** the Z-axis moving mechanism includes
a molding die stage which elongates in a Z-axis direction to support the molding die; and
a guide member which is shaped to be tubular to guide the molding die stage in the Z-axis direction,
wherein the Z air slide guide mechanism includes a plurality of ejection holes to eject air to the Z guide in different directions,
wherein, under a condition that the control device has deactivated the XY air slide guide mechanism, and a condition that the control device has deactivated some ejection holes of the Z air slide guide mechanism to make the molding die stage to come into contact with the guide member,
the control device controls the Z-axis moving mechanism to make the molding die to elevate toward the glass substrate which is supported by the stage.

4. The device for producing the wafer lens, described in Claim 3, **characterized in that** said device includes a position detecting device which detects an arranged position of the molding die,
wherein an initial position of the molding die has been preset in the control device by an axial coordinate,
wherein under a condition that the control device has locked the XY air slide guide mechanism and the Z air slide guide mechanism,
the control device obtains a real arranged position of the molding die, based on an detected result sent from the position detecting device, and
the control device transforms the axial coordinate of the initial position of the molding die to agree with the real position of the molding die.

5. The device for producing the wafer lens, described in Claim 3, **characterized in that** said device includes a position detecting device which detects an arranged position of the molding die,
wherein the initial position of the molding die has been preset in the control device by the axial coordinate,
wherein under a condition that the control device has locked the XY air slide guide mechanism, and a condition that the control device has partly locked the Z air slide guide mechanism to make the molding die to come into contact with the guide member,
the control device obtains a real arranged position of the molding die, based on an detected result sent from the position detecting device, and
the control device transforms the axial coordinate of the initial position of the molding die to agree with the real position of the molding die.

6. A method for producing a wafer lens, characterizing the steps of:
moving a glass substrate along an XY guide on an XY-plane to a position to face a molding die, while making the glass substrate to float by supply of first air,;
arranging the molding die at a predetermined height position by elevating or lowering the molding die along a Z guide to, while making a molding die to float by supply of second air; and
elevating the molding die toward the glass substrate,
wherein in the step of elevating the molding die,
under a condition that the supply of the first air and the supply of the second air have been stopped,
the molding die is elevated toward the glass substrate.

7. The method for producing the wafer lens, described in Claim 6, **characterized in that** in the step of elevating the molding die,
under a condition that the supply of the first air has been stopped, and a condition that the supply of the second air has been partly stopped, to make the Z-stage which supports the molding die to come into contact with the Z guide,
the molding die is elevated toward the glass substrate.

8. The method for producing the wafer lens, described in Claim 6, further characterizing the steps of:
setting an initial position of the molding die as an axial coordinate; and
obtaining a real arranged position of the molding die, and transforming the axial coordinate of the initial position of the molding die to agree with the real arranged position of the molding die, under a condition that the supplies of the first air and the second air have been stopped.

9. The method for producing the wafer lens, described in Claim7, further characterizing the steps of:
setting an initial position of the molding die as an axial coordinate; and
obtaining a real arranged position of the molding die, and transforming the axial coordinate of the initial position of the molding die to agree with the real arranged position of the molding die,
under a condition that the supply of the first air has been stopped, and a condition that the supply of the second air has partly been stopped, to make the Z stage which supports the molding die to come into contact with the Z guide.
